Europäisches Patentamt

European Patent Office

Office européen des brevets

(19)

(11) Veröffentlichungsnummer: **0 093 432**
**A2**

(12) # EUROPÄISCHE PATENTANMELDUNG

(21) Anmeldenummer: **83104234.6**

(22) Anmeldetag: **29.04.83**

(51) Int. Cl.³: **H 05 K 7/14**
**H 05 K 9/00**

(30) Priorität: **30.04.82 DE 3216267**

(43) Veröffentlichungstag der Anmeldung:
**09.11.83 Patentblatt 83/45**

(84) Benannte Vertragsstaaten:
**FR GB IT NL SE**

(71) Anmelder: **SIEMENS AKTIENGESELLSCHAFT**
**Berlin und München Wittelsbacherplatz 2**
**D-8000 München 2(DE)**

(72) Erfinder: **Voigt, Ulrich, Dipl.-Ing.**
**Unertistrasse 31**
**D-8000 München 40(DE)**

(72) Erfinder: **Engel, Albert**
**Akilindastrasse 52**
**D-8032 Gräfelfing(DE)**

(54) Datenstationssystem.

(57) Die Erfindung bezieht sich auf ein Datenstationssystem mit einer aus Flachbaugruppen bestehenden zentralen Steuereinheit und mehreren an diese anschließbare periphere Geräte. In der Regel erfolgt dabei die Verbindung der peripheren Geräte mit diesen Flachbaugruppen so, daß diese mit einem Anschlußfeld verbunden sind und die externen Verbindungsleitungen zu den peripheren Geräten an dieses Anschlußfeld herangeführt werden. Demgegenüber sieht die Erfindung vor, daß an der vorderen Längsseite der Flachbaugruppen 1 je ein Winkel 2 angebracht ist, der den Zwischenraum der nebeneinanderliegenden Flachbaugruppen 1 abdeckt und daß auf diese Winkel für jede auf der Flachbaugruppe befindliche Schnittstelle jeweils ein Signalstecker 10 und ein zugehöriger Kodierschalter 4 befestigt ist. Dadurch entsteht ein aus Teilanschlußfeldern zusammengesetztes, den Flachbaugruppen unmittelzugeordnetes Anschlußfeld, so daß die interne Verdrahtung zwischen Anschlußfeld und Flachbaugruppen entfallen kann.

SIEMENS AKTIENGESELLSCHAFT          Unser Zeichen
Berlin und München                  VPA 82 P 1 3 5 6 E

Datenstationssysteme.

Die Erfindung betrifft ein Datenstationssystem mit einer aus Flachbaugruppen aufgebauten zentralen Steuereinheit und mehreren an diese anschließbare periphere Geräte.

Bei Datenstationssystemen sind jeweils Schnittstellen vorgesehen, über die der Anschluß mehrerer peripherer Geräte an die zentrale Steuereinheit erfolgt. Dabei führen die externen Schnittstellenleitungen an einen Schnittstellenstecker des Anschlußfeldes und von dort über eine zusätzliche geräteinterne Leitung im geschirmten Geräteraum jeweils weiter zum Signalleitungsstecker der entsprechenden Schnittstellenflachbaugruppe. Dabei beinhaltet die interne Leitung auf einem Anschlußwinkel neben einem mehrpoligen Signalstecker auch noch den dazugehörigen Kodierschalter.

Aufgabe der vorliegenden Erfindung ist es, diesen Verdrahtungsaufwand zu verringern.

Zur Lösung dieser Aufgabe wird das Datenstationssystem derart ausgebildet, daß an der vorderen Längsseite der Flachbaugruppe je ein Winkel mit elektromagnetischen Schirmeigenschaften angebracht ist, der den Zwischenraum der nebeneinanderliegenden Flachbaugruppen stirnseitig abdeckt und daß auf diesem Winkel für jede Schnittstelle auf der Flachbaugruppe jeweils ein Signalstecker und ein zugeordneter Kodierschalter befestigt ist und daß die Zuleitung von den peripheren Geräten unmittelbar an diese Schnittstellen herangeführt ist.

Zk 1 Fdl/ 30. 4. 1982

0093432

Durch diese Maßnahmen erhält man ein Anschlußfeld, das aus den Teilanschlußfeldern der einzelnen Schnittstellenflachbaugruppen entsteht. Ein eigenes Schaltfeld, das zwischen dem Anschluß der externen Leitung für die peripheren Geräte und den Schnittstellenflachbaugruppen angeordnet ist, entfällt dadurch, so daß auch die zwischen diesem Anschlußfeld und den Flachbaugruppen sonst übliche Verdrahtung entfallen kann. Die Schnittstellenflachbaugruppen erhalten damit eine unmittelbare Leitung zu den peripheren Geräten.

Zur HF-dichten Befestigung dieses Winkels ist es vorteilhaft, auf beiden Schmalseiten je eine über den Winkel vorstehende Lasche vorzusehen.

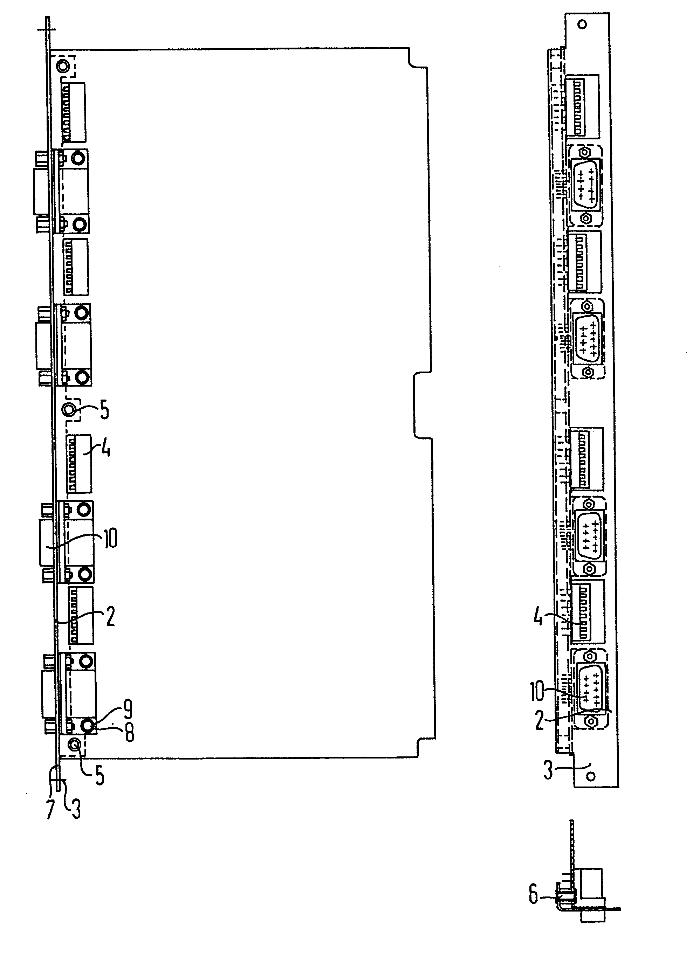

Die Erfindung wird anhand der Figur näher erläutert. In der Figur ist links eine Seitenansicht einer Flachbaugruppe mit aufgeschraubtem Winkel, rechts eine Voransicht und darunter eine Seitenansicht dargestellt.

Auf der Flachbaugruppe 1 ist der Winkel 2 mit Schrauben 5 befestigt. Der Winkel 2 hat dabei eine Breite, die den Abstand zweier Flachbaugruppen, die nebeneinander in einer Platterfunktionseinheit eingeschoben sind, entspricht. Auf der Vorderfront dieses Winkels 2 sind die Signalstecker 10 und die Kodierschalter 4 abwechselnd angeordnet. Jeder Schnittstelle auf der Flachbaugruppe ist jeweils ein Signalleitungsstecker 10 und ein Kodierschalter 4 zugeordnet. Die nebeneinanderliegenden Winkel 2 der einzelnen Flachbaugruppen bilden so ein Anschlußfeld. Gleichzeitig bilden sie eine zusammengesetzte Schirmwand. Sie sind für den Anschluß der peripheren Geräte und die Betätigung der Kodierschalter direkt zugänglich. Für Flachbaugruppen ohne externen Anschluß können geschlossene Winkel und für Leerplätze aufgeschraubte Abdeckstreifen vorgesehen sein, so daß die elektromagnetische Geschlossenheit des aus Teilanschlußfeldern zusammengesetzten Anschlußfeldes gewahrt bleibt.

Die Leitungen von den peripheren Geräte, wie z. B.
Tastaturen, Universaldruckern, Anzeigeeinheiten, Ausweislesern und dergl. führen dabei unmittelbar an diese sogenannten Schnittstellenflachbaugruppen und nicht,
wie bei bekannten Geräten, an ein eigenes Anschlußfeld,
das wiederum mit den Schnittstellenflachbaugruppen
geräteintern verbunden ist. Dadurch wird nicht nur Verdrahtung eingespart, was zu einer Platzreduzierung führt,
sondern darüber hinaus wird auch eine bessere Entkopplung
der einzelnen Flachbaugruppen voneinander erreicht.

1 Figur
2 Patentansprüche.

0093432

<u>Patentansprüche</u>

1. Datenstationssystem mit einer aus Flachbaugruppen aufgebauten zentralen Steuereinheit und mehreren an diese anschließbare periphere Geräte, d a d u r c h   g e - k e n n z e i c h n e t, daß an der vorderen Längsseite der Flachbaugruppe (1) je ein Winkel (2) angebracht ist, der den Zwischenraum der nebeneinanderliegenden Flachbaugruppen (1) abdeckt, und daß auf diesem Winkel für jede auf der Flachbaugruppe befindlichen Schnittstelle jeweils ein Signalleitungsstecker (10) und ein zugehöriger Kodierschalter (4) befestigt ist und daß die Zuleitung von den peripheren Geräten unmittelbar an diese Flachbaugruppenwinkel (2) herangeführt ist.

2. Datenstationssystem nach Anspruch 1, d a d u r c h   g e k e n n z e i c h n e t, daß der Winkel (2) auf beiden Schmalseiten mit je einer über den Winkel (2) vorstehenden Lasche (3) versehen ist.